(19) Europäisches Patentamt
European Patent Office
Office européen des brevets

(11) EP 4 671 336 A1

(12) EUROPEAN PATENT APPLICATION

(43) Date of publication:
31.12.2025 Bulletin 2026/01

(21) Application number: 25182988.3

(22) Date of filing: 16.06.2025

(51) International Patent Classification (IPC):
*C09J 7/38* $^{(2018.01)}$ *H01L 21/683* $^{(2006.01)}$

(52) Cooperative Patent Classification (CPC):
**C09J 7/385; H01L 21/6836;** C09J 133/04; C09J 2203/326; C09J 2301/312; C09J 2301/416; C09J 2433/00; H01L 2221/68327; H01L 2221/68381

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: 28.06.2024 JP 2024105697

(71) Applicant: **Nitto Denko Corporation**
**Ibaraki-shi, Osaka 567-8680 (JP)**

(72) Inventors:
- **Chiba, Mizuho**
**Ibaraki-shi, Osaka, 567-8680 (JP)**
- **Mizobata, Kaori**
**Ibaraki-shi, Osaka, 567-8680 (JP)**

(74) Representative: **Grünecker Patent- und Rechtsanwälte PartG mbB**
**Leopoldstraße 4**
**80802 München (DE)**

# (54) PRESSURE-SENSITIVE ADHESIVE TAPE

(57) Provided is a pressure-sensitive adhesive tape that has an excellent pressure-sensitive adhesive strength, and that can achieve both of adhesiveness to an adherend and peelability. The pressure-sensitive adhesive tape includes a base material; and a pressure-sensitive adhesive layer formed of an active energy ray-curable pressure-sensitive adhesive. A surface of the pressure-sensitive adhesive layer after active energy ray irradiation has a microphase-separated structure including an island portion and a sea portion having a storage elastic modulus higher than a storage elastic modulus of the island portion, in a storage elastic modulus mapping image obtained with an atomic force microscope.

FIG.1

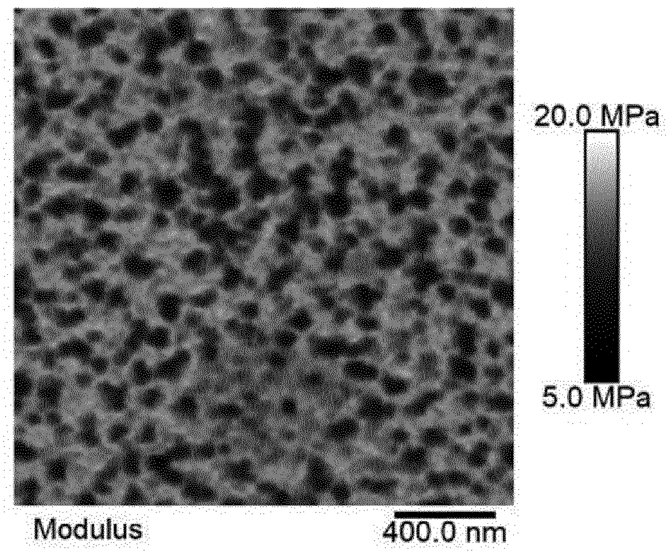


EP 4 671 336 A1

## Description

BACKGROUND OF THE INVENTION

1. Field of the Invention

The present invention relates to a pressure-sensitive adhesive tape.

2. Description of the Related Art

A pressure-sensitive adhesive tape has been widely used for the purposes of surface protection and fixation of an adherend. For example, in a processing process for a semiconductor wafer, the pressure-sensitive adhesive tape is used for appropriately holding the semiconductor wafer serving as the adherend in each of a backgrinding step and a dicing step. In recent years, miniaturization and thinning of a chip have been advanced, and such a pressure-sensitive adhesive strength that the semiconductor wafer can be appropriately held even when thinly ground at the time of processing is required.

SUMMARY OF THE INVENTION

A pressure-sensitive adhesive tape including a pressure-sensitive adhesive layer having a high pressure-sensitive adhesive strength can hold a semiconductor wafer at the time of processing. The wafer after the processing has a small thickness and thus tends to easily break, and hence the wafer may break at the time of the peeling of the pressure-sensitive adhesive tape. Accordingly, a light-peelable pressure-sensitive adhesive tape that can be easily peeled from an adherend after the processing has been required. As such pressure-sensitive adhesive tape, a pressure-sensitive adhesive tape using a UV-curable pressure-sensitive adhesive has been proposed (for example, Japanese Patent Application Laid-open No. 2019-31620). However, even when such pressure-sensitive adhesive tape is used, for example, chip fly may occur at the time of dicing because of a lack of a sufficient pressure-sensitive adhesive strength, or a chip crack may occur at the time of pickup because the pressure-sensitive adhesive strength is not sufficiently reduced even after active energy ray irradiation.

1. According to at least one embodiment of the present invention, there is provided a pressure-sensitive adhesive tape, including: a base material; and a pressure-sensitive adhesive layer formed of an active energy ray-curable pressure-sensitive adhesive, wherein a surface of the pressure-sensitive adhesive layer after active energy ray irradiation has a microphase-separated structure including an island portion and a sea portion having a storage elastic modulus higher than a storage elastic modulus of the island portion, in a storage elastic modulus mapping image obtained with an atomic force microscope.

2. In the pressure-sensitive adhesive tape according to the above-mentioned item 1, the island portion may have a size of 300 nm or less.

3. In the pressure-sensitive adhesive tape according to the above-mentioned item 1 or 2, the active energy ray-curable pressure-sensitive adhesive may be a water-dispersed pressure-sensitive adhesive.

4. In the pressure-sensitive adhesive tape according to any one of the above-mentioned items 1 to 3, the active energy ray-curable pressure-sensitive adhesive may contain a water-dispersed acrylic polymer and an active energy ray-curable resin.

5. In the pressure-sensitive adhesive tape according to the above-mentioned item 4, the water-dispersed acrylic polymer may be a polymer having a core-shell type structure.

6. In the pressure-sensitive adhesive tape according to the above-mentioned item 4 or 5, the water-dispersed acrylic polymer may include a shell portion having a glass transition temperature Tg of -10°C or more and a core portion having a glass transition temperature Tg of less than -10°C.

7. The pressure-sensitive adhesive tape according to any one of the above-mentioned items 1 to 6 may be used for semiconductor wafer processing.

According to at least one embodiment of the present invention, there can be provided the pressure-sensitive

adhesive tape that has an excellent pressure-sensitive adhesive strength, and that can achieve both of adhesiveness to an adherend and light peelability.

BRIEF DESCRIPTION OF THE DRAWINGS

FIG. 1 is a storage elastic modulus mapping image of a pressure-sensitive adhesive layer surface of a pressure-sensitive adhesive tape according to at least one embodiment of the present invention after active energy ray irradiation, the image being obtained with an atomic force microscope.

FIG. 2 is a schematic sectional view of a pressure-sensitive adhesive tape according to at least one embodiment of the present invention.

FIG. 3 is a storage elastic modulus mapping image of a pressure-sensitive adhesive layer surface of a pressure-sensitive adhesive tape of Example 1 after active energy ray irradiation, the image being obtained with an atomic force microscope.

FIG. **4** is a storage elastic modulus mapping image of a pressure-sensitive adhesive layer surface of a pressure-sensitive adhesive tape of Example 2 after active energy ray irradiation, the image being obtained with an atomic force microscope.

FIG. **5** is a storage elastic modulus mapping image of a pressure-sensitive adhesive layer surface of a pressure-sensitive adhesive tape of Example 3 after active energy ray irradiation, the image being obtained with an atomic force microscope.

FIG. **6** is a storage elastic modulus mapping image of a pressure-sensitive adhesive layer surface of a pressure-sensitive adhesive tape of Example 4 after active energy ray irradiation, the image being obtained with an atomic force microscope.

FIG. **7** is a storage elastic modulus mapping image of a pressure-sensitive adhesive layer surface of a pressure-sensitive adhesive tape of Comparative Example 1 after active energy ray irradiation, the image being obtained with an atomic force microscope.

FIG. **8** is a storage elastic modulus mapping image of a pressure-sensitive adhesive layer surface of a pressure-sensitive adhesive tape of Comparative Example 2 after active energy ray irradiation, the image being obtained with an atomic force microscope.

DESCRIPTION OF THE EMBODIMENTS

A. Overall Configuration of Pressure-sensitive Adhesive Tape

A pressure-sensitive adhesive tape according to at least one embodiment of the present invention includes: a base material; and a pressure-sensitive adhesive layer formed of an active energy ray-curable pressure-sensitive adhesive. In the pressure-sensitive adhesive layer, a surface of the pressure-sensitive adhesive layer after active energy ray irradiation has a microphase-separated structure including an island portion and a sea portion having a storage elastic modulus higher than a storage elastic modulus of the island portion (hereinafter also referred to as "microphase-separated structure serving as a sea-island structure"), in a storage elastic modulus mapping image (hereinafter also referred to as "elastic modulus mapping image") obtained with an atomic force microscope. FIG. 1 is a storage elastic modulus mapping image of a pressure-sensitive adhesive layer surface of a pressure-sensitive adhesive tape according to at least one embodiment of the present invention after active energy ray irradiation, the image being obtained with an atomic force microscope. The atomic force microscope (AFM) is a microscope for detecting an atomic force that acts between a probe and a sample. When storage elastic modulus mapping is performed with the AFM, distribution information of storage elastic moduli in the pressure-sensitive adhesive layer surface is obtained. As shown in FIG. 1, when the pressure-sensitive adhesive layer surface after the active energy ray irradiation is subjected to the storage elastic modulus mapping with the AFM, a portion having a relatively low storage elastic modulus serves as the island portion, and a portion having a storage elastic modulus higher than the storage elastic modulus of the island portion serves as the sea portion. When the elastic modulus mapping image of the pressure-sensitive adhesive layer surface after the active energy ray irradiation has

such sea-island structure, a pressure-sensitive adhesive that forms the sea portion after the active energy ray irradiation tends to have polarity higher than that of a pressure-sensitive adhesive that forms the island portion after the active energy ray irradiation. For example, when an active energy ray-curable resin is used as an active energy ray-curable component, a larger amount of the active energy ray-curable resin may be present in a pressure-sensitive adhesive having higher polarity (that is, a pressure-sensitive adhesive that forms the sea portion after the active energy ray irradiation). Accordingly, the sea portion serving as a continuous phase is easily cured than the island portion after the active energy ray irradiation, a sea having elasticity higher than that of the island portion is formed, and hence a curing shrinkage amount of the sea portion may increase. As a result, a light-peelable pressure-sensitive adhesive tape that can be more lightly peeled can be obtained. Herein, the storage elastic modulus mapping image of the pressure-sensitive adhesive layer surface after the active energy ray irradiation, the image being obtained with the AFM, refers to the result of storage elastic modulus mapping measurement performed under the following conditions.

<Storage Elastic Modulus Mapping Measurement>

The pressure-sensitive adhesive tape is irradiated with an active energy ray from a base material side thereof through use of an active energy ray irradiation apparatus (e.g., manufactured by Nitto Seiki Co., Ltd., product name: "UM-810") so as to achieve an integrated light quantity of 460 $mJ/cm^2$. The calibration of the deflection sensitivity and spring constant of a cantilever is performed in the Peak Force QNM mode of the AFM. A release liner is peeled from the pressure-sensitive adhesive tape irradiated with the active energy ray, and elastic modulus mapping is performed under the following conditions to provide a storage elastic modulus mapping image.

• Measurement Mode

Apparatus name: manufactured by Bruker, atomic force microscope, model: MultiMode 8
Mode: Peak Force QNM tapping mode
Scan size: 2 μm×2 μm
Scan speed: 1.0 Hz
Maximum number of samples: 256×256 samples/line
Peak force setpoint: 20 nN
Peak force frequency: 2 kHz
Modulus fit model: Johnson-Kendall-Roberts (JKR)
Frequency (F): 70 Hz
• Cantilever
Model: 240AC-NA (MikroMasch)
Spring constant: 2 N/m

In the elastic modulus mapping image of the pressure-sensitive adhesive layer surface after the active energy ray irradiation, the size of the island portion is preferably 300 nm or less, more preferably 250 nm or less, still more preferably 200 nm or less. In addition, the size of the island portion is, for example, 50 nm or more. When the size of the island portion falls within the above-mentioned ranges, mass production can be industrially stably performed even in the case of a water-dispersed pressure-sensitive adhesive. Herein, the size of the island portion refers to the length of a part of each island portion having the maximum length, and may be measured by subjecting the elastic modulus mapping image to image processing.

The ratio of the island portion in the pressure-sensitive adhesive layer surface after the active energy ray irradiation is preferably from 10% to 80%, more preferably from 10% to 70%, still more preferably from 30% to 70%. When the ratio of the island portion falls within the above-mentioned ranges, there can be obtained a pressure-sensitive adhesive tape that appropriately holds an adherend until its peeling even after active energy ray irradiation, and that prevents the adherend from being broken at the time of the peeling even when the adherend is a micro and/or thin layer.

FIG. 2 is a schematic sectional view of a pressure-sensitive adhesive tape according to at least one embodiment of the present invention. A pressure-sensitive adhesive tape 100 includes a base material 20 and a pressure-sensitive adhesive layer 10 in the stated order. As described above, in the pressure-sensitive adhesive layer 10, the surface of the pressure-sensitive adhesive layer after active energy ray irradiation has a microphase-separated structure including an island portion having a small storage elastic modulus and a sea portion having a storage elastic modulus higher than the storage elastic modulus of the island portion, in the storage elastic modulus mapping image obtained with an atomic force microscope. Any appropriate state may be adopted for the microphase-separated structure of the surface of the pressure-sensitive adhesive layer before and after the active energy ray irradiation. The pressure-sensitive adhesive tape according

to at least one embodiment of the present invention can exhibit excellent adhesiveness to an adherend before the active energy ray irradiation. In addition, when the surface of the pressure-sensitive adhesive layer has the above-mentioned microphase-separated structure serving as a sea-island structure, the curing shrinkage of the pressure-sensitive adhesive layer after the active energy ray irradiation becomes larger. Thus, there can be obtained a pressure-sensitive adhesive tape that can be easily peeled from the adherend after the active energy ray irradiation. The pressure-sensitive adhesive tape 100 may further include any appropriate layer. For example, an intermediate layer (not shown) may be formed between the base material **20** and the pressure-sensitive adhesive layer **10.** When the tape includes the intermediate layer, adhesiveness to an adherend having unevenness on its surface can be improved.

In the pressure-sensitive adhesive tape, the pressure-sensitive adhesive strength to a Si wafer of the pressure-sensitive adhesive tape before the active energy ray irradiation is preferably 2 N/20 mm or more, more preferably 4 N/20 mm or more, still more preferably 5 N/20 mm or more. When the pressure-sensitive adhesive strength to the Si wafer before the active energy ray irradiation falls within the above-mentioned ranges, the pressure-sensitive adhesive tape has sufficient adhesiveness to an adherend. In addition, the pressure-sensitive adhesive strength to the Si wafer is, for example, 15 N/20 mm or less. Herein, the pressure-sensitive adhesive strength to the Si wafer refers to a pressure-sensitive adhesive strength measured by the following method. The pressure-sensitive adhesive tape is cut out into a size of 20 mm wide by 80 mm long, and is pressure-bonded to the mirror surface of a silicon mirror wafer by reciprocating a hand roller once under an atmosphere at 23°C. The resultant is left to stand at 23°C for 30 minutes. After that, a strength required for peeling the pressure-sensitive adhesive tape is measured by performing a 90° peeling test at a tensile rate of 300 mm/min under an atmosphere at 23°C and 50%RH.

The pressure-sensitive adhesive strength to the Si wafer of the pressure-sensitive adhesive tape after the tape has been subjected to UV irradiation so as to achieve an integrated light quantity of 460 mJ/cm$^2$ is preferably less than 0.25 N/20 mm, more preferably 0.2 N/20 mm or less, still more preferably 0.15 N/20 mm or less. When the pressure-sensitive adhesive strength to the Si wafer after the irradiation with UV light serving as an active energy ray falls within the above-mentioned ranges, the pressure-sensitive adhesive tape has light peelability. The pressure-sensitive adhesive strength after the active energy ray (UV) irradiation is preferably as small as possible. Herein, the pressure-sensitive adhesive strength to the Si wafer of the pressure-sensitive adhesive tape after the tape has been subjected to UV irradiation so as to achieve an integrated light quantity of 460 mJ/cm$^2$ refers to a value measured by the following method. The pressure-sensitive adhesive tape is cut out into a size of 20 mm wide by 80 mm long, and is pressure-bonded to the mirror surface of a silicon mirror wafer by reciprocating a hand roller once under an atmosphere at 23°C. The resultant is left to stand at 23°C for 30 minutes. After that, UV light is radiated from a pressure-sensitive adhesive tape surface side so as to achieve an integrated light quantity of 460 mJ/cm$^2$ (365 nm conversion). Next, a strength required for peeling the pressure-sensitive adhesive tape is measured by performing a 90° peeling test under an atmosphere at 23°C and 50%RH and under the condition of a tensile rate of 300 mm/min.

The thickness of the pressure-sensitive adhesive tape according to at least one embodiment of the present invention may be set to any appropriate thickness. The thickness of the pressure-sensitive adhesive tape is preferably from 30 μm to 400 μm, more preferably from 40 μm to 300 um, still more preferably from 50 μm to 200 μm.

## A-1. Base Material

The base material may be formed of any appropriate resin. Specific examples of the resin for forming the base material include polyester-based resins, such as polyethylene naphthalate (PEN), polybutylene terephthalate (PBT), and polybutylene naphthalate (PBN), polyolefin-based resins, such as an ethylenevinyl acetate copolymer, an ethylene-methyl methacrylate copolymer, polyethylene, polypropylene, and an ethylenepropylene copolymer, polyvinyl alcohol, polyvinylidene chloride, polyvinyl chloride, a vinyl chloride-vinyl acetate copolymer, polyvinyl acetate, polyamide, polyimide, celluloses, a fluorine-based resin, polyether, polystyrene-based resins such as polystyrene, polycarbonate, polyether sulfone, and polyetheretherketone. Of those, polyolefin-based resins or polyester-based resins are preferred. Those resins each transmit UV light, and hence can each form the pressure-sensitive adhesive layer with a UV-curable pressure-sensitive adhesive to provide a pressure-sensitive adhesive tape having light peelability.

The base material may further contain another component to the extent that the effects of the present invention are not impaired. Examples of the other component include an antioxidant, a UV absorber, a light stabilizer, a heat stabilizer, and an antistatic agent. With regard to the kind and usage amount of the other component, the component may be used in any appropriate amount in accordance with purposes.

The thickness of the base material is preferably from 30 μm to 200 μm, more preferably from 40 μm to 180 μm, still more preferably from 45 μm to 180 μm.

## A-2. Pressure-sensitive Adhesive Layer

The pressure-sensitive adhesive layer of the pressure-sensitive adhesive tape according to at least one

embodiment of the present invention is formed of an active energy ray-curable pressure-sensitive adhesive. A typical example of the active energy ray-curable pressure-sensitive adhesive is a UV-curable pressure-sensitive adhesive. The active energy ray-curable pressure-sensitive adhesive is preferably a water-dispersed pressure-sensitive adhesive. A pressure-sensitive adhesive containing a water-dispersed acrylic polymer, an active energy ray-curable resin, and a photopolymerization initiator is preferably used as the water-dispersed pressure-sensitive adhesive. When such pressure-sensitive adhesive is used, the pressure-sensitive adhesive tape has an excellent pressure-sensitive adhesive strength, and hence can exhibit excellent adhesiveness to an adherend. In addition, a pressure-sensitive adhesive layer surface has a microphase-separated structure serving as a sea-island structure in an elastic modulus mapping image after active energy ray irradiation, and hence there can be provided a water-dispersed pressure-sensitive adhesive that can achieve both of adhesiveness and light peelability. In addition, while such pressure-sensitive adhesive is an aqueous pressure-sensitive adhesive composition, the pressure-sensitive adhesive has an excellent pressure-sensitive adhesive strength, and can achieve both of adhesiveness to an adherend and light peelability. Accordingly, there can be provided a pressure-sensitive adhesive that can reduce an environmental load by reducing the usage amount of a solvent, and that can be suitably used in a processing process for a semiconductor wafer.

A-2-1. Water-dispersed Acrylic Polymer

The water-dispersed acrylic polymer (hereinafter also referred to as "acrylic polymer") may be obtained by subjecting any appropriate monomer component to emulsion polymerization in water. That is, the water-dispersed acrylic polymer is an emulsion of an acrylic polymer. The average particle diameter of the acrylic polymer emulsion is preferably from 80 nm to 400 nm, more preferably from 100 nm to 300 nm, still more preferably from 100 nm to 200 nm. Herein, the average particle diameter of the water-dispersed acrylic polymer refers to a volume-based median diameter (D50) measured by a laser diffraction-scattering method.

In at least one embodiment of the present invention, the water-dispersed acrylic polymer is preferably a polymer having a core-shell type structure (hereinafter also referred to as "core-shell polymer"). When the water-dispersed acrylic polymer serving as a core-shell polymer is used, there can be provided a pressure-sensitive adhesive that has a more excellent pressure-sensitive adhesive strength before active energy ray irradiation, and that can achieve both of adhesiveness to an adherend and light peelability.

The water-dispersed acrylic polymer serving as a core-shell polymer is obtained by subjecting any appropriate monomer component to emulsion polymerization in a stepwise manner. The water-dispersed acrylic polymer may be obtained by, for example, so-called seed polymerization including subjecting a monomer composition for forming a core portion to emulsion polymerization by any appropriate method, and then subjecting a monomer composition for forming a shell portion to emulsion polymerization in the presence of the generated polymer particles serving as a core portion.

The core ratio of the water-dispersed acrylic polymer serving as a core-shell polymer is preferably 5 wt% or more, more preferably 10 wt% or more. When the weight ratio between the core portion and the shell portion falls within the above-mentioned ranges, there can be provided a water-dispersed pressure-sensitive adhesive composition that has an excellent pressure-sensitive adhesive strength, and that can achieve both of adhesiveness to an adherend and light peelability.

The core-shell polymer preferably includes a shell portion having a glass transition temperature Tg of -10°C or more, and a core portion having a glass transition temperature Tg of less than -10°C. When such core-shell polymer is used, there can be obtained a pressure-sensitive adhesive tape that has an excellent pressure-sensitive adhesive strength before active energy ray irradiation, and that can be peeled without breakage of an adherend after the active energy ray irradiation.

The glass transition temperature Tg of the shell portion is preferably -10°C or more, more preferably -5°C or more, still more preferably 0°C or more. The glass transition temperature Tg of the shell portion is, for example, 50°C or less. The glass transition temperature Tg of the core portion is preferably less than -10°C, more preferably -20°C or less, still more preferably -30°C or less, particularly preferably - 35°C or less. The glass transition temperature Tg of the core portion is, for example, -60°C or more. When the glass transition temperatures Tg of the core portion and the shell portion fall within the above-mentioned ranges, there can be provided a pressure-sensitive adhesive tape having a satisfactory pressure-sensitive adhesive property before active energy ray irradiation, and satisfactory peelability after the active energy ray irradiation.

Herein, the glass transition temperature of the water-dispersed acrylic polymer refers to a theoretical value calculated by Fox's equation from monomer units for forming each polymer and ratios thereof. The theoretical glass transition temperature determined by Fox's equation may be consistent with an actually measured glass transition temperature determined by a method, such as differential scanning calorimetry (DSC) or dynamic viscoelasticity measurement. As described later, when the theoretical value cannot be calculated, the actually measured glass transition temperature may be used.

As described below, Fox's equation is a relational equation between the Tg of an acrylic polymer and the glass

transition temperature Tgi of a homopolymer obtained by homopolymerizing each of monomers for forming the acrylic polymer:

$$1/Tg=\Sigma(Wi/Tgi)$$

where Tg represents the glass transition temperature (unit: K) of the acrylic polymer, Wi represents the weight fraction (copolymerization ratio on a weight basis) of a monomer "i" in the acrylic polymer, and Tgi represents the glass transition temperature (unit: K) of the homopolymer of the monomer "i".

A value described in any appropriate material may be used as the glass transition temperature of the homopolymer to be used in the calculation of the Tg. For example, for monomers listed below, the following values are used as glass transition temperatures of the homopolymers of the monomers.

| | |
|---|---|
| 2-Ethylhexyl acrylate | -70°C |
| Methyl methacrylate | 8°C |
| Acrylic acid | 106°C |
| 2-Acryloyloxyethyl succinate | -40°C |
| 4-Hydroxybutyl acrylate | -40°C |
| N-Acryloylomorpholine | 145°C |

A numerical value described in, for example, "Polymer Handbook" (3rd edition, John Wiley & Sons, Inc., 1989) may be used as the glass transition temperature of the homopolymer of a monomer except those listed above. When a plurality of kinds of values are described, the highest value is adopted.

A value obtained by a measurement method as described in Japanese Patent Application Laid-open No. 2007-51271 may be used for such a monomer that the glass transition temperature of a homopolymer thereof is not described in the above-mentioned Polymer Handbook. Specifically, 100 parts by weight of the monomer, 0.2 part by weight of azobisisobutyronitrile, and 200 parts by weight of ethyl acetate serving as a polymerization solvent are loaded into a reactor including a temperature gauge, a stirring machine, a nitrogen-introducing tube, and a reflux condenser, and are stirred for 1 hour while a nitrogen gas is flowed in the reactor. After oxygen in a polymerization system has been removed as described above, a temperature in the reactor is increased to 63°C and the mixture is subjected to a reaction for 10 hours. Next, the resultant is cooled to room temperature to provide a homopolymer solution having a solid content concentration of 33 wt%. Next, the homopolymer solution is cast onto a release liner, and is dried to produce a test sample having a thickness of about 2 mm (sheet-shaped homopolymer). The test sample is punched into a disc shape having a diameter of 7.9 mm. The disc is sandwiched between parallel plates, and its viscoelasticity is measured with a viscoelasticity tester (ARES, manufactured by Rheometric Scientific, Inc.) in the temperature region of from -70°C to 150°C at a rate of temperature increase of 5°C/min by a shear mode while a shear strain having a frequency of 1 Hz is applied to the disc. The peak top temperature of the tanδ of the disc is defined as the Tg of the homopolymer.

A-2-2. Monomer Component

The composition of the monomer composition to be used in the formation of each of the core portion and the shell portion may be adjusted so that a core portion or shell portion having any appropriate glass transition temperature is formed. For example, a monomer may be selected based on Fox's equation described above so that a core portion or shell portion having a designed glass transition temperature Tg is obtained, and may be subjected to emulsion polymerization.

Any appropriate acrylic monomer may be used as the monomer component. A (meth)acrylic acid alkyl ester is used as a typical monomer component. Specific examples of the (meth)acrylic acid alkyl ester include (meth)acrylic acid C1 to C20 alkyl esters, such as methyl (meth)acrylate, ethyl (meth)acrylate, propyl (meth)acrylate, isopropyl (meth)acrylate, butyl (meth)acrylate, isobutyl (meth)acrylate, s-butyl (meth)acrylate, t-butyl (meth)acrylate, pentyl (meth)acrylate, hexyl (meth)acrylate, heptyl (meth)acrylate, octyl (meth)acrylate, 2-ethylhexyl (meth)acrylate, isooctyl (meth)acrylate, nonyl (meth)acrylate, isononyl (meth)acrylate, decyl (meth)acrylate, isodecyl (meth)acrylate, undecyl (meth)acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicoscyl (meth)acrylate. The (meth)acrylic acid alkyl esters may be used alone or in combination thereof. Herein, the term " (meth)acryl" refers to acryl and/or methacryl.

The monomer composition may further contain any appropriate other monomer copolymerizable with the (meth)acrylic acid alkyl ester. Examples thereof include: carboxyl group-containing monomers, such as acrylic acid and methacrylic acid; acid anhydride monomers, such as maleic anhydride and itaconic anhydride; hydroxyl group-containing

monomers including hydroxyalkyl (meth)acrylates, such as 2-hydroxyethyl (meth)acrylate, 2-hydroxypropyl (meth) acrylate, 2-hydroxybutyl (meth)acrylate, 3-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl)methyl (meth)acrylate; sulfonic acid group-containing monomers, such as styrenesulfonic acid and allylsulfonic acid; (N-substituted) amide-based monomers, such as diacetone acrylamide, (meth)acrylamide, and N,N-dimethyl (meth)acrylamide; aminoalkyl (meth)acrylate-based monomers such as aminoethyl (meth)acrylate; alkoxyalkyl (meth)acrylate-based monomers such as methoxyethyl (meth)acrylate; maleimide-based monomers, such as N-cyclohexylmaleimide and **N-**isopropylmaleimide; itaconimide-based monomers, such as **N-**methylitaconimide and N-ethylitaconimide; succinimide-based monomers; vinyl-based monomers, such as vinyl acetate, vinyl propionate, N-vinylpyrrolidone, and methylvinylpyrrolidone; cyanoacrylate monomers, such as acrylonitrile and methacrylonitrile; epoxy group-containing acrylic monomers such as glycidyl (meth)acrylate; glycol-based acrylic ester monomers, such as polyethylene glycol (meth)acrylate and polypropylene glycol (meth)acrylate; acrylic acid ester-based monomers each having a heterocycle, a halogen atom, a silicon atom, or the like, such as tetrahydrofurfuryl (meth)acrylate, fluorine (meth) acrylate, and silicone (meth)acrylate; olefin-based monomers, such as isoprene, butadiene, and isobutylene; and vinyl ether-based monomers such as vinyl ether. The incorporation of those monomer components can modify, for example, cohesive strength, heat resistance, or cross-linkability. Those monomer components may be used alone or in combination thereof.

In at least one embodiment of the present invention, an amide group-containing monomer is preferably used as a monomer component for forming the shell portion. Specific examples of the amide group-containing monomer include: acrylamide-based monomers, such as (meth)acrylamide, N,N-dimethyl (meth)acrylamide, N,N-diethyl (meth)acrylamide, N-isopropyl acrylamide, N-methyl (meth)acrylamide, N-butyl (meth)acrylamide, N-hexyl (meth)acrylamide, N-methylol (meth)acrylamide, **N-**methylol-N-propane (meth)acrylamide, aminomethyl (meth)acrylamide, aminoethyl (meth)acrylamide, mercaptomethyl (meth)acrylamide, and mercaptoethyl (meth)acrylamide; N-acryloyl heterocyclic monomers, such as N-(meth)acryloylmorpholine, N-(meth)acryloylpiperidine, and N-(meth)acryloylpyrrolidine; and N-vinyl group-containing lactam-based monomers, such as N-vinylpyrrolidone and N-vinyl-ε-caprolactam. Of those, N-(meth)acryloylmorpholine, N,N-diethyl (meth)acrylamide, and N-isopropyl acrylamide are preferred, and N-acryloylmorpholine is more preferred. When the amide group-containing monomer is used as the monomer to be used for the polymerization of the shell portion, the initial pressure-sensitive adhesive strength of the pressure-sensitive adhesive layer can be improved. The content ratio of the amide group-containing monomer in all monomers for forming the shell portion is, for example, from 0.01 wt% to 10 wt%, preferably from 0.1 wt% to 7 wt%.

In at least one embodiment of the present invention, the acrylic polymer is preferably a polymer obtained by polymerizing a monomer composition containing a carboxyl group-containing monomer represented by the formula (1) as a monomer component. When the acrylic polymer is a core-shell polymer, the carboxyl group-containing monomer represented by the formula (1) may be incorporated only in the monomer composition to be used for the polymerization of the core portion, may be incorporated only in the monomer composition to be used for the polymerization of the shell portion, or may be incorporated in the monomer composition to be used for the polymerization of the core portion and the monomer composition to be used for the polymerization of the shell portion. The carboxyl group-containing monomers may be used alone or in combination thereof.

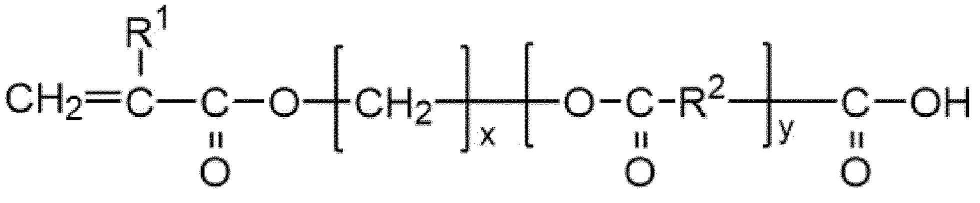

(1)

In the formula, $R^1$ represents a hydrogen atom or a methyl group, $R^2$ represents a divalent hydrocarbon group, "x" represents an integer of from 1 to 20, and "y" represents 0 or 1.

$R^1$ represents a hydrogen atom or a methyl group. "x" represents an integer of from 1 to 20, preferably an integer of from 1 to 10, more preferably an integer of from 1 to 8. "y" represents 0 or 1. $R^2$ represents a divalent hydrocarbon group. Examples of the divalent hydrocarbon group include: saturated aliphatic hydrocarbon groups such as an alkylene group; saturated alicyclic hydrocarbon groups such as a cycloalkylene group; aromatic hydrocarbon groups such as a phenylene group; unsaturated aliphatic hydrocarbon groups; and unsaturated alicyclic hydrocarbon groups. $R^2$ represents preferably a linear or branched alkylene group or a cycloalkylene group, more preferably a linear or branched alkylene group having 1 to 20 carbon atoms or a cycloalkylene group, still more preferably a linear or branched alkylene group having 1 to 10 carbon atoms or a cycloalkylene group. When "x" falls within the above-mentioned ranges and $R^2$ represents the above-mentioned divalent hydrocarbon group, a pressure-sensitive adhesive excellent in dispersion stability and applicability can be obtained.

Specific examples of the carboxyl group-containing monomer represented by the formula (1) include 2-acryloyloxyethyl succinate, 2-methacryloyloxyethyl succinate, 2-acryloyloxyethyl hexahydrophthalate, ω-carboxy-polycaprolactone (n≈2) monoacrylate, and 2-methacryloyloxyethyl hexahydrophthalate.

A commercially available product may be used as the carboxyl group-containing monomer represented by the formula (1). Examples of the commercially available product include: products available under the product names "HOA-MS", "Light Ester HO-MS(N)", and "Light Acrylate HOA-HH(N)" from Kyoeisha Chemical Co., Ltd.; and a product available under the product name "ARONIX M-5300" from Toagosei Co., Ltd.

The content ratio of the carboxyl group-containing monomer represented by the formula (1) is preferably from 3 parts by weight to 30 parts by weight, more preferably from 4 parts by weight to 25 parts by weight, still more preferably from 4 parts by weight to 20 parts by weight, particularly preferably from 6 parts by weight to 15 parts by weight with respect to 100 parts by weight of monomer components (in the case of the core-shell polymer, monomer components to be used for the polymerization of the core portion or monomer components to be used for the polymerization of the shell portion). When the content ratio of the carboxyl group-containing monomer represented by the formula (1) falls within the above-mentioned ranges, a pressure-sensitive adhesive excellent in dispersion stability and applicability can be obtained.

A-2-3. Surfactant

Any appropriate surfactant may be used as a surfactant. A reactive surfactant may be preferably used. The reactive surfactant has a radically polymerizable functional group (e.g., a radical reactive group, such as an ethenyl group, a propenyl group, an allyl group, or an allyl ether group) in a molecule thereof while having a function as a surfactant. When the reactive surfactant is used, the contamination of an adherend by the pressure-sensitive adhesive in which the water-dispersed acrylic polymer is used can be reduced, and the pressure-sensitive adhesive strength of the pressure-sensitive adhesive composition before radiation irradiation treatment can be improved. In addition, the water resistance of the pressure-sensitive adhesive tape (e.g., the pressure-sensitive adhesive layer) using the pressure-sensitive adhesive composition is improved, and hence the peeling of the pressure-sensitive adhesive tape can be suppressed even when the tape is brought into contact with water at the time of the processing.

The reactive surfactant is, for example, a surfactant obtained by introducing a radically polymerizable functional group (radical reactive group), such as a propenyl group or an allyl ether group, to any appropriate surfactant (e.g., an anionic surfactant or a nonionic surfactant). The reactive surfactant has a radically polymerizable functional group according to an ethylenically unsaturated double bond, and can reduce the saturated water absorption ratio of the pressure-sensitive adhesive layer to be formed as compared to a nonreactive surfactant. Further, the reactive surfactants to be preferably used may be used alone or in combination thereof from the viewpoints of the stability of a water dispersion liquid and the durability of the pressure-sensitive adhesive layer.

Specific examples of the anionic surfactant include: higher fatty acid salts such as sodium oleate; alkylaryl sulfonic acid salts such as sodium dodecylbenzene sulfonate; alkyl sulfuric acid ester salts, such as sodium lauryl sulfate and ammonium lauryl sulfate; polyoxyethylene alkyl ether sulfuric acid ester salts such as sodium polyoxyethylene lauryl ether sulfate; polyoxyethylene alkylaryl ether sulfuric acid ester salts such as sodium polyoxyethylene nonylphenyl ether sulfate; alkyl sulfosuccinic acid ester salts and derivatives thereof, such as sodium monooctyl sulfosuccinate, sodium dioctyl sulfosuccinate, and sodium polyoxyethylene lauryl sulfosuccinate; and polyoxyethylene distyrenated phenyl ether sulfuric acid ester salts. Specific examples of the nonionic surfactant include: polyoxyethylene alkyl ethers, such as polyoxyethylene lauryl ether and polyoxyethylene stearyl ether; polyoxyethylene alkylphenyl ethers, such as polyoxyethylene octylphenyl ether and polyoxyethylene nonylphenyl ether; sorbitan higher fatty acid esters, such as sorbitan monolaurate, sorbitan monostearate, and sorbitan trioleate; polyoxyethylene sorbitan higher fatty acid esters such as polyoxyethylene sorbitan monolaurate; polyoxyethylene higher fatty acid esters, such as polyoxyethylene monolaurate and polyoxyethylene monostearate; glycerin higher fatty acid esters, such as oleic acid monoglyceride and stearic acid monoglyceride; and a polyoxyethylene-polyoxypropylene-block copolymer and polyoxyethylene distyrenated phenyl ether.

A commercially available product may be used as the reactive surfactant. Specific examples of the anionic reactive surfactant include: alkyl ether-based reactive surfactants, such as products available under the product names "AQUALON KH-05", "AQUALON KH-10", and "AQUALON KH-20" fromDKS Co. Ltd., products available under the product names "ADEKA REASOAP SR-10N" and "ADEKA REASOAP SR-20N" from Asahi Denka Co., Ltd., and a product available under the product name "LATEMUL PD-104" from Kao Corporation; sulfosuccinic acid ester-based reactive surfactants, such as products available under the product names "LATEMUL S-120", "LATEMUL S-120A", "LATEMUL S-180P", and "LATEMUL S-180A" from Kao Corporation, and a product available under the product name "ELEMINOL JS-20" from Sanyo Chemical Industries, Ltd.; alkylphenyl ether-based or alkylphenyl ester-based reactive surfactants, such as products available under the product names "AQUALON H-2855A", "AQUALON H-3855B", "AQUALON H-3855C", "AQUALON H-3856", "AQUALON HS-05", "AQUALON HS-10", "AQUALON HS-20", "AQUALON HS-30", "AQUALON BC-05", "AQUALON BC-10", and "AQUALON BC-20" from DKS Co. Ltd., and products available under the

product names "ADEKA REASOAP SDX-222", "ADEKA REASOAP SDX-223", "ADEKA REASOAP SDX-232", "ADEKA REASOAP SDX-233", "ADEKA REASOAP SDX-259", "ADEKA REASOAP SE-10N", and "ADEKA REASOAP SE-20N" from Asahi Denka Co., Ltd.; (meth)acrylate sulfuric acid ester-based reactive surfactants, such as products available under the product names "ANTOX MS-60" and "ANTOX MS-2N" from Nippon Nyukazai Co., Ltd., and a product available under the product name "ELEMINOL RS-30" from Sanyo Chemical Industries, Ltd.; and phosphoric acid ester-based reactive surfactants, such as a product available under the product name "H-3330PL" from DKS Co. Ltd., and a product available under the product name "ADEKA REASOAP PP-70" from Asahi Denka Co., Ltd. Specific examples of the nonionic reactive surfactant include: alkyl ether-based reactive surfactants, such as products available under the product names "ADEKA REASOAP ER-10", "ADEKA REASOAP ER-20", "ADEKA REASOAP ER-30", and "ADEKA REASOAP ER-40" from Asahi Denka Co., Ltd., and products available under the product names "LATEMUL PD-420", "LATEMUL PD-430", and "LATEMUL PD-450" from Kao Corporation; alkylphenyl ether-based or alkylphenyl ester-based reactive surfactants, such as products available under the product names "AQUALON RN-10", "AQUALON RN-20", "AQUALON RN-30", and "AQUALON RN-50" from DKS Co. Ltd., and products available under the product names "ADEKA REASOAP NE-10", "ADEKA REASOAP NE-20", "ADEKA REASOAP NE-30", and "ADEKA REASOAP NE-40" from Asahi Denka Co., Ltd.; and (meth)acrylate sulfuric acid ester-based reactive surfactants, such as products available under the product names "RMA-564", "RMA-568", and "RMA-1114" from Nippon Nyukazai Co., Ltd.

The anionic reactive surfactant is preferably used as the reactive surfactant. The anionic reactive surfactant is preferred because the surfactant is excellent in polymerization stability in many cases, and from the viewpoints of particle stability and appearance. The anionic reactive surfactant and the nonionic reactive surfactant may be used in combination.

In at least one embodiment of the present invention, the reactive surfactant preferably has a concentration of a $SO_4^{2-}$ion of 100 $\mu$g/g or less. In addition, the reactive surfactant is preferably an ammonium salt-type surfactant. The pressure-sensitive adhesive tape according to at least one embodiment of the present invention may be a pressure-sensitive adhesive tape to be used in a processing process for a semiconductor wafer. Accordingly, an impurity ion in the pressure-sensitive adhesive may be a problem. Accordingly, the content of the impurity ion in the pressure-sensitive adhesive is preferably as low as possible. When the concentration of the $SO_4^{2-}$ ion falls within the above-mentioned range, and when the ammonium salt-type surfactant is used, adverse effects of the impurity ion can be suppressed. Any appropriate method, such as an ion-exchange resin method, a membrane separation method, or a method of precipitating and filtering an impurity with an alcohol, may be used as a method of reducing or removing the impurity ion.

The reactive surfactant is used in any appropriate amount. The content of the reactive surfactant is preferably from 0.1 part by weight to 5 parts by weight, more preferably from 0.5 part by weight to 3 parts by weight with respect to 100 parts by weight of the monomer composition. When the content of the reactive surfactant is more than 5 parts by weight with respect to 100 parts by weight of the monomer composition, in the case where the pressure-sensitive adhesive composition is used for a pressure-sensitive adhesive tape for semiconductor wafer processing, a small element piece may be peeled from the pressure-sensitive adhesive tape in a dicing step or a subsequent step. In addition, when the content of the reactive surfactant is less than 0.1 part by weight with respect to 100 parts by weight of the monomer composition, a stable emulsion state may not be maintained.

In addition, the reactive surfactant and a surfactant free of any radically polymerizable functional group may be used in combination. Examples of the surfactant free of any radically polymerizable functional group include: anionic surfactants or nonionic anionic surfactants, such as sodium lauryl sulfate, ammonium lauryl sulfate, sodium dodecylbenzene sulfonate, a sodium polyoxyethylene alkyl ether sulfate, an ammonium polyoxyethylene alkylphenyl ether sulfate, a sodium polyoxyethylene alkylphenyl ether sulfate, and a sodium polyoxyethylene alkyl sulfosuccinate; and nonionic surfactants, such as a polyoxyethylene alkyl ether, a polyoxyethylene alkylphenyl ether, a polyoxyethylene fatty acid ester, and a polyoxyethylene polyoxypropylene block polymer. Those surfactants may be used alone or in combination thereof.

A-2-4. Method of polymerizing Water-dispersed Acrylic Polymer

The water-dispersed acrylic polymer may be polymerized by any appropriate method. For example, the water-dispersed acrylic polymer may be obtained by adding water such as ion-exchanged water, a monomer composition, a surfactant, a polymerization initiator, and any appropriate additive to a reaction vessel, followed by mixing, and performing emulsion polymerization. When the water-dispersed acrylic polymer is a core-shell polymer, the water-dispersed acrylic polymer serving as a core-shell polymer may be obtained, for example, by: loading and mixing a monomer composition containing monomers for forming a core portion, water, a surfactant, a polymerization initiator, and any appropriate additive in a reaction vessel, followed by emulsion polymerization to form polymer particles serving as a core portion; and then loading and mixing a monomer composition containing monomers for forming a shell portion, water, a surfactant, a polymerization initiator, and any appropriate additive in the reaction vessel, followed by emulsion polymerization to form a shell portion. Examples of the any appropriate additive include a chain transfer agent and a silane coupling agent.

Any appropriate polymerization initiator may be used as the polymerization initiator. Examples thereof include:

azo-based polymerization initiators, such as 2,2'-azobisisobutyronitrile, 2,2'-azobis(2-amidinopropane) dihydrochloride, 2,2'-azobis[2-(5-methyl-2-imidazolin-2-yl)propane] dihydrochloride, 2,2'-azobis(2-methylpropionamidine) disulfate, and 2,2'-azobis(N,N'-dimethyleneisobutylamidine); persulfates, such as potassium persulfate and ammonium persulfate; peroxide-based polymerization initiators, such as benzoyl peroxide, t-butyl hydroperoxide, and hydrogen peroxide; and redox-based initiators each based on a combination of a peroxide and a reducing agent [e.g., redox-based polymerization initiators based on a combination of a peroxide and ascorbic acid (e.g., a combination of hydrogen peroxide water and ascorbic acid), a combination of a peroxide and an iron(II) salt (e.g., a combination of hydrogen peroxide water and an iron(II) salt), and a combination of a persulfate and sodium hydrogen sulfite]. The polymerization initiators may be used alone or in combination thereof.

The polymerization initiator may be used in any appropriate amount in accordance with, for example, the kind of the polymerization initiator to be used and the composition of the monomer composition. The content of the polymerization initiator is, for example, from 0.01 part by weight to 1 part by weight, preferably from 0.02 part by weight to 0.5 part by weight with respect to 100 parts by weight of the monomer composition.

The chain transfer agent may be used for, for example, adjusting the molecular weight of the water-dispersed acrylic polymer. Any appropriate chain transfer agent may be used as the chain transfer agent. Specific examples thereof include lauryl mercaptan, glycidyl mercaptan, mercaptoacetic acid, 2-mercaptoethanol, thioglycolic acid, 2-ethylhexyl thioglycolate, and 2,3-dimercapto-1-propanol. The chain transfer agents may be used alone or in combination thereof. The content of the chain transfer agent is typically from 0.001 part by weight to 0.5 part by weight with respect to 100 parts by weight of the monomer composition.

The water-dispersed acrylic polymer is obtained by subjecting the monomer composition, the reactive surfactant, the polymerization initiator, and any appropriate additive such as the chain transfer agent to emulsion polymerization. Accordingly, the water-dispersed acrylic polymer may be prepared in the form of an emulsion. Any appropriate method may be used as a method for the emulsion polymerization. A specific example thereof is an emulsion polymerization method utilizing a general method, such as a collective loading method (collective polymerization method), a monomer dropping method, or a monomer emulsion dropping method. When a monomer or the like is dropped, the monomer may be continuously dropped or may be dividedly dropped. A polymerization temperature may be set to any appropriate value in accordance with, for example, the kind of the polymerization initiator, and may be set to, for example, the range of from 5°C to 100°C. In addition, an alkali aqueous solution, such as ammonia water, any of various water-soluble amines, a sodium hydroxide aqueous solution, or a potassium hydroxide aqueous solution, is preferably further added to a solution of the water-dispersed acrylic polymer obtained by the emulsion polymerization to adjust the pH to, for example, from 6 to 11, preferably from 7 to 10.

The gel fraction of the water-dispersed acrylic polymer is preferably 50 wt% or more, more preferably 70 wt% or more. When the gel fraction of the water-dispersed acrylic polymer is less than 50 wt%, a pressure-sensitive adhesive strength after active energy ray irradiation is hardly reduced, and the contamination of an adherend by a sol content is liable to occur. The gel fraction of the water-dispersed acrylic polymer is, for example, 99 wt% or less. The gel fraction of the water-dispersed acrylic polymer may be determined by any appropriate method. For example, the gel fraction may be determined as an insoluble content with respect to a solvent such as ethyl acetate. Specifically, the gel fraction is determined as the weight fraction (unit: wt%) of an insoluble component after the immersion of the water-dispersed acrylic polymer in ethyl acetate at 23°C for 7 days with respect to a sample before the immersion.

## A-3. Active Energy Ray-curable Resin

Any appropriate resin that can be cured by an active energy ray such as UV light may be used as the active energy ray-curable resin. A UV-curable resin is preferably used. For example, a UV-curable monomer and/or oligomer may be used as the UV-curable resin. Examples of the UV-curable monomer include urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, and 1,4-butanediol di(meth)acrylate. Examples of the UV-curable oligomer include a urethane-based oligomer, a polyether-based oligomer, a polyester-based oligomer, a polycarbonate-based oligomer, and a polybutadiene-based oligomer. An oligomer having a molecular weight of from about 100 to about 30,000 is preferably used as the oligomer. The monomers and the oligomers may be used alone or in combination thereof. The active energy ray-curable resin may be emulsified with any appropriate surfactant or self-emulsifiable urethane (meth)acrylate as required. When the emulsification is performed, the preparation of the water-dispersed pressure-sensitive adhesive can be easily performed.

A commercially available product may be used as the active energy ray-curable resin. Examples thereof include a product available under the product name "ETERNACOLL UW-9102" from UBE Corporation, a product available under the product name "HYDRAN Exp UV-100S" from DIC Corporation, products available under the product names "BEAMSET EM-90" and "BEAMSET EM-94" from Arakawa Chemical Industries, Ltd., products available under the product names "UCECOAT 7655", "UCECOAT 7200", and "UCECOAT 7773" from Daicel-Allnex Ltd., and products

available under the product names "FOM-03006" and "FOM-03009" from FUJIFILM Wako Pure Chemical Corporation. An aqueous resin (water dispersion of a resin) may be appropriately selected and used from the viewpoint of the compatibility of the active energy ray-curable resin with the water-dispersed acrylic polymer.

The active energy ray-curable resin may be used in any appropriate amount in accordance with, for example, the kind of the water-dispersed acrylic polymer. The amount is, for example, preferably from 5 parts by weight to 200 parts by weight, more preferably from 20 parts by weight to 150 parts by weight, still more preferably from 50 parts by weight to 150 parts by weight with respect to 100 parts by weight of the water-dispersed acrylic polymer.

A-4. Photopolymerization Initiator

Any appropriate initiator may be used as the photopolymerization initiator. Examples of the photopolymerization initiator include: acyl phosphine oxide-based photopolymerization initiators, such as ethyl 2,4,6-trimethylbenzylphenyl phosphinate and (2,4,6-trimethylbenzoyl)-phenylphosphine oxide; α-ketol-based compounds, such as 4-(2-hydroxyethoxy)phenyl(2-hydroxy-2-propyl) ketone, α-hydroxy-α,α'-dimethylacetophenone, 2-methyl-2-hydroxypropiophenone, and 1-hydroxycyclohexyl phenyl ketone; acetophenone-based compounds, such as methoxyacetophenone, 2,2-dimethoxy-2-phenylacetophenone, 2,2-diethoxyacetophenone, and 2-methyl-1-[4-(methylthio)-phenyl]-2-morpholinopropane-1; benzoin ether-based compounds, such as benzoin ethyl ether, benzoin isopropyl ether, and anisoin methyl ether; ketal-based compounds such as benzyl dimethyl ketal; aromatic sulfonyl chloride-based compounds such as 2-naphthalenesulfonyl chloride; photoactive oxime-based compounds such as 1-phenone-1,1-propanedione-2-(o-ethoxycarbonyl)oxime; benzophenone-based compounds, such as benzophenone, benzoylbenzoic acid, and 3,3'-dimethyl-4-methoxybenzophenone; thioxanthone-based compounds, such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketones; and acyl phosphonates, and α-hydroxyacetophenones such as 2-hydroxy-1-(4-(4-(2-hydroxy-2-methylpropionyl)benzyl)phenyl)-2-methylpropane-1. The photopolymerization initiators may be used alone or in combination thereof. A photopolymerization initiator that is liquid at room temperature (e.g., 23°C) is preferably used because the photopolymerization initiator is soluble in (compatible with) a water-dispersed acrylic polymer solution.

A commercially available product may be used as the photopolymerization initiator. Examples thereof include products available under the product names "Omnirad 500", "Omnirad TPO-L", "Omnirad MBF", and "Omnirad 1173" from IGM Resins B.V.

The photopolymerization initiator may be used in any appropriate amount. The content of the photopolymerization initiator is preferably from 0.5 part by weight to 20 parts by weight, more preferably from 1 part by weight to 10 parts by weight with respect to 100 parts by weight of the water-dispersed acrylic polymer. When the content of the photopolymerization initiator is less than 0.5 part by weight, the water-dispersed pressure-sensitive adhesive composition may not be sufficiently cured at the time of active energy ray irradiation. When the content of the photopolymerization initiator is more than 20 parts by weight, the storage stability of the water-dispersed pressure-sensitive adhesive composition may be reduced.

A-5. Cross-linking Agent

In at least one embodiment of the present invention, the pressure-sensitive adhesive composition may further contain a cross-linking agent. When the cross-linking agent is used, the gel fraction of the pressure-sensitive adhesive composition can be adjusted. Any appropriate cross-linking agent may be used as the cross-linking agent. Examples thereof include bifunctional or higher epoxy-based cross-linking agents, isocyanate-based cross-linking agents, carbodiimide-based cross-linking agents, oxazoline-based cross-linking agents, aziridine-based cross-linking agents, melamine resin-based cross-linking agents, metal chelate-based cross-linking agents, peroxide-based cross-linking agents, and hydrazine-based cross-linking agents. The cross-linking agents may be used alone or in combination thereof.

Specific examples of the cross-linking agent include: epoxy-based cross-linking agents, such as N,N,N',N'-tetraglycidyl-m-xylenediamine, 1,3-bis(N,N-glycidylaminomethyl) cyclohexane, and 1,6-hexanediol diglycidyl ether; isocyanate-based cross-linking agents (e.g., blocked isocyanate-based cross-linking agents) such as tolylene diisocyanate (blocked); carbodiimide-based cross-linking agents such as a product available under the product name "CARBODILITE V-01" (from Nisshinbo Chemical Inc.); epoxy-based cross-linking agents, such as polyethylene glycol diglycidyl ether and polyglycerol polyglycidyl ether; water-dispersed isocyanate-based cross-linking agents such as a product available under the product name "ELASTRON BN-69" (from DKS Co. Ltd.); oxazoline-based cross-linking agents such as a product available under the product name "EPOCROS WS-500" (from Nippon Shokubai Co., Ltd.); aziridine-based cross-linking agents such as a product available under the product name "CHEMITITE PZ-33" (from Nippon Shokubai Co., Ltd.); hydrophilically treated carbodiimide-based cross-linking agents such as products available under the product names "CARBODILITE V-02" and "CARBODILITE V-04" (from Nisshinbo Chemical Inc.); cross-linking agents each

having an active methylol group or an active alkoxymethyl group including an active methylol such as hexamethylolmelamine and an active alkoxymethyl such as hexamethoxymethylmelamine; metal chelate-based cross-linking agents such as a product available under the product name "ORGATIX AI135" (from Matsumoto Fine Chemical Co., Ltd.); and hydrazine-based cross-linking agents, such as adipic dihydrazide and phthalic dihydrazide.

The content of the cross-linking agent is, for example, from 0.01 part by weight to 10 parts by weight, preferably from 0.05 part by weight to 5 parts by weight, more preferably from 0.1 part by weight to 3 parts by weight with respect to 100 parts by weight of the water-dispersed acrylic polymer. As described above, the water-dispersed pressure-sensitive adhesive composition may be free of any cross-linking agent (that is, the content of the cross-linking agent may be 0 parts by weight).

A-6. Additive

The pressure-sensitive adhesive may contain any appropriate additive as required. Examples of the additive include a catalyst (e.g., a platinum catalyst), a tackifier, a plasticizer, a pigment, a dye, a filler, an age resistor, a conductive material, a UV absorber, a light stabilizer, a peeling modifier, a softener, a flame retardant, and a solvent. The additive is used in any appropriate amount in accordance with purposes.

The thickness of the pressure-sensitive adhesive layer may be set to any appropriate value. The thickness of the pressure-sensitive adhesive layer is preferably from 2 μm to 200 μm, more preferably from 3 μm to 150 um, still more preferably from 5 μm to 100 μm. When the thickness of the pressure-sensitive adhesive layer falls within the above-mentioned ranges, a sufficient pressure-sensitive adhesive strength to an adherend can be exhibited.

B. Method of producing Pressure-sensitive Adhesive Tape

The pressure-sensitive adhesive tape according to at least one embodiment of the present invention may be produced by any appropriate method. The pressure-sensitive adhesive tape may be obtained, for example, by: applying the pressure-sensitive adhesive to a release liner, followed by drying to form a pressure-sensitive adhesive layer on the release liner; and then transferring the pressure-sensitive adhesive layer to the base material. In addition, the pressure-sensitive adhesive tape may be obtained by applying the pressure-sensitive adhesive onto the base material, followed by drying. Various methods, such as bar coating, air knife coating, gravure coating, gravure reverse coating, reverse roll coating, lip coating, die coating, dip coating, offset printing, flexographic printing, and screen printing, may each be adopted as a method of applying the pressure-sensitive adhesive. Any appropriate method may be adopted as a method for the drying.

C. Application of Pressure-sensitive Adhesive Tape

The pressure-sensitive adhesive tape according to at least one embodiment of the present invention can be suitably used in a production process for a semiconductor wafer. The pressure-sensitive adhesive tape can be used as, for example, a dicing tape or a backgrinding tape. As described above, the pressure-sensitive adhesive tape according to at least one embodiment of the present invention appropriately holds the adherend before active energy ray irradiation, and the pressure-sensitive adhesive tape can be peeled without breakage of the adherend after the active energy ray irradiation even when the adherend is a micro and/or thin layer. Accordingly, the pressure-sensitive adhesive tape can also be suitably used for the processing of a semiconductor wafer having a thinner and more complicated structure.

Examples

The present invention is specifically described below by way of Examples, but the present invention is not limited to these Examples. In addition, "part(s)" and "%" in Examples are by weight unless otherwise stated.

[Synthesis Example 1] Synthesis of Acrylic Polymer A

180 Parts by weight of water, 62 parts by weight of 2-ethylhexyl acrylate (2EHA), 23 parts by weight of methyl methacrylate (MMA), 10 parts by weight of a carboxyl group-containing monomer (HOA-MS) (2-acryloyloxyethyl succinate, manufactured by Kyoeisha Chemical Co., Ltd., product name: "HOA-MS"), 5 parts by weight of 4-hydroxybutyl acrylate (4HBA) (manufactured by Osaka Organic Chemical Industry Ltd., product name: "4-HBA"), and 3 parts by weight of a reactive surfactant (manufactured by DKS Co. Ltd., product name: "AQUALON HS-1025") were mixed in a reaction vessel including a condenser, a nitrogen-introducing tube, a temperature gauge, and a stirring device, and the mixture was stirred and emulsified with a homomixer. Next, while the emulsion was stirred, the reaction vessel was purged with nitrogen for 1 hour. Subsequently, an inner bath temperature during polymerization was controlled to 60°C. 0.04 Part by weight of a

water-soluble azo initiator (manufactured by FUJIFILM Wako Pure Chemical Corporation, product name: "VA-057") was added thereto to initiate the polymerization. Heating was performed for 2 hours. Thus, a core portion was produced.

Next, 90 parts by weight of water, 35 parts by weight of 2EHA, 45 parts by weight of MMA, 10 parts by weight of HOA-MS, 5 parts by weight of HBA, 5 parts by weight of acryloylmorpholine (ACMO), and 1 part by weight of the reactive surfactant (manufactured by DKS Co. Ltd., product name: "AQUALON HS-1025") were mixed, and the mixture was stirred with a homomixer to produce a monomer emulsion for a shell. 0.2 Part by weight of the water-soluble azo initiator (manufactured by FUJIFILM Wako Pure Chemical Corporation, product name: "VA-057") was added to the water-dispersed solution having dispersed therein the core particles. After an induction time period of 10 minutes, the emulsified monomer emulsion solution for a shell was added over 2 hours, and then an aging reaction was further performed for 2 hours. Thus, a core-shell type water-dispersed acrylic polymer A was produced.

[Synthesis Examples 2 to 4] Synthesis of Acrylic Polymers B to D

Core-shell type water-dispersed acrylic polymers B to D were each obtained in the same manner as in Synthesis Example 1 except that the monomer compositions of the core portion and the shell portion were changed as shown in Table 1.

[Synthesis Example 5] Synthesis of Acrylic Polymer E

180 Parts by weight of water, 47.5 parts by weight of 2EHA, 35 parts by weight of MMA, 10 parts by weight of HOA-MS, 5 parts by weight of 4HBA, 2.5 parts by weight of ACMO, and 2 parts by weight of a reactive surfactant (manufactured by DKS Co. Ltd., product name: "AQUALON KH-1025") were loaded into a reaction vessel including a condenser, a nitrogen-introducing tube, a temperature gauge, and a stirring device, and the mixture was stirred and emulsified with a homomixer. Next, while the emulsion was stirred, the reaction vessel was purged with nitrogen for 1 hour. Subsequently, an inner bath temperature during polymerization was controlled to 60°C. Next, 0.1 part by weight of a water-soluble azo initiator (manufactured by FUJIFILM Wako Pure Chemical Corporation, product name: "VA-057") was added thereto to initiate the polymerization. Heating was performed for 5 hours. Thus, a water-dispersed acrylic polymer E was synthesized.

Table 1

| | | A | B | C | D | E |
|---|---|---|---|---|---|---|
| Core | 2EHA | 62 | 58 | 72 | 34 | 47.5 |
| | MMA | 23 | 27 | 26 | 51 | 35 |
| | AA | - | - | 2 | - | - |
| | HOA-MS | 10 | 10 | - | 10 | 10 |
| | 4HBA | 5 | 5 | - | 5 | 5 |
| | ACMO | - | - | - | - | 2.5 |
| | KH-1025 | 3 | 5 | - | 3 | 2 |
| | JS-20 | - | - | 4.5 | - | - |
| Shell | 2EHA | 35 | 24 | 45 | 66 | - |
| | MMA | 45 | 56 | 53 | 25 | - |
| | HOA-MS | 10 | 10 | 2 | 9 | - |
| | 4HBA | 5 | 5 | - | - | - |
| | ACMO | 5 | 5 | - | | |
| | KH-1025 | 1 | 0.7 | - | 0.5 | - |
| | JS-20 | - | - | 1.5 | - | - |
| Core/shell ratio | | 50/50 | 30/70 | 50/50 | 50/50 | 100/0 |
| Initia tor | Core | 0.04 | 0.07 | 0.02 | 0.04 | 0.02 |
| | Shell | 0.1 | 0.15 | 0.04 | 0.1 | - |

(continued)

| | | A | B | C | D | E |
|---|---|---|---|---|---|---|
| Tg | Core | -40°C | -35°C | -40°C | 0°C | -21°C |
| | Shell | 0°C | 19°C | -1°C | -40°C | - |

2EHA: 2-ethylhexyl acrylate
MMA: methyl methacrylate
AA: acrylic acid
HOA-MS: manufactured by Kyoeisha Chemical Co., Ltd., product name: "HOA-MS(N)" (2-acryloyloxyethyl succinate)
4HBA: manufactured by Osaka Organic Chemical Industry Ltd., product name: "4-HBA" (4-hydroxybutyl acrylate)
ACMO: acryloylmorpholine
KH-1025: surfactant, manufactured by DKS Co. Ltd., product name: "AQUALON KH-1025"
JS-20: surfactant, manufactured by Sanyo Chemical Industries, Ltd., product name: "ELEMINOL JS-20"

[Example 1]

100 Parts by weight of the acrylic polymer, 100 parts by weight of a UV-curable resin (manufactured by UBE Corporation, product name: "ETERNACOLL UW-9102"), 0.2 part by weight of a cross-linking agent (manufactured by Nisshinbo Chemical Inc., product name: "CARBODILITE V-04"), and 3 parts by weight of a photopolymerization initiator (manufactured by IGM Resins B.V., product name: "Omnirad TPO-L") were loaded and mixed. After that, the mixture was neutralized with 10% ammonia water to produce a water-dispersed solution. The resultant pressure-sensitive adhesive solution was applied to the silicone release treatment surface of a polyester film (thickness: 38 μm) subjected to silicone release treatment so that its thickness after drying became 20 μm. The resultant was dried at 125°C for 3 minutes to form a pressure-sensitive adhesive layer. Next, a polyolefin (PO)-based film (thickness: 80 μm) subjected to surface oxidation treatment by corona discharge was bonded to the pressure-sensitive adhesive layer-side surface of the pressure-sensitive adhesive layer so that the pressure-sensitive adhesive layer was transferred. Thus, a pressure-sensitive adhesive tape was produced.

[Example 2]

A pressure-sensitive adhesive tape was obtained in the same manner as in Example 1 except that: the core-shell type water-dispersed acrylic polymer B was used instead of the core-shell type water-dispersed acrylic polymer A; and no cross-linking agent was added.

[Example 3]

A pressure-sensitive adhesive tape was obtained in the same manner as in Example 2 except that 50 parts by weight of UW-9102 and 50 parts by weight of UV-W300 (manufactured by Mitsubishi Chemical Corporation, product name: "SHIKOH UV-W300") were used as the UV-curable resins.

[Example 4]

A pressure-sensitive adhesive tape was obtained in the same manner as in Example 1 except that: the core-shell type water-dispersed acrylic polymer C was used instead of the core-shell type water-dispersed acrylic polymer A; no cross-linking agent was added; and 1 part by weight of a thickener (manufactured by San Nopco Limited, product name: "SN-THICKENER 612") and 1 part by weight of a leveling agent (manufactured by DKS Co. Ltd., product name: "NEOCOL SW-C") were added.

(Comparative Example 1)

A pressure-sensitive adhesive tape was obtained in the same manner as in Example 2 except that the core-shell type water-dispersed acrylic polymer D was used instead of the core-shell type water-dispersed acrylic polymer B.

(Comparative Example 2)

A pressure-sensitive adhesive tape was obtained in the same manner as in Example 3 except that the water-dispersed acrylic polymer E was used instead of the core-shell type water-dispersed acrylic polymer C.

<Evaluation>

The following evaluations were performed by using the water-dispersed acrylic polymers used in Examples and Comparative Examples and the resultant pressure-sensitive adhesive tapes. The results are shown in Table 2.

1. Glass Transition Temperature

The glass transition temperatures of the water-dispersed acrylic polymers obtained in Synthesis Examples 1 to 5 were each calculated from Fox's equation described below:

$$1/Tg=\Sigma(Wi/Tgi)$$

where Tg represents the glass transition temperature (unit: K) of the acrylic polymer, Wi represents the weight fraction (copolymerization ratio on a weight basis) of a monomer "i" in the acrylic polymer, and Tgi represents the glass transition temperature (unit: K) of the homopolymer of the monomer "i".

The following values were used as the glass transition temperatures of homopolymers of monomers.

| | |
|---|---|
| 2-Ethylhexyl acrylate | -70°C |
| Methyl methacrylate | 8°C |
| Acrylic acid | 106°C |
| 2-Acryloyloxyethyl succinate | -40°C |
| 4-Hydroxybutyl acrylate | -40°C |
| N-Acryloylomorpholine | 145°C |

2. Storage Elastic Modulus Mapping Measurement

The pressure-sensitive adhesive tape was irradiated with an active energy ray from a base material side thereof through use of an active energy ray irradiation apparatus (manufactured by Nitto Seiki Co., Ltd., product name: "UM-810") so as to achieve an integrated light quantity of 460 mJ/cm$^2$. The calibration of the deflection sensitivity and spring constant of a cantilever was performed in the Peak Force QNM mode of an atomic force microscope (AFM). A release liner was peeled from the pressure-sensitive adhesive tape irradiated with the active energy ray, and elastic modulus mapping was performed under the following conditions to provide a storage elastic modulus mapping image. Mapping images of the pressure-sensitive adhesive tapes of Examples and Comparative Examples are shown in FIG. **3** to FIG. **8.**

•Measurement Mode

Apparatus name: manufactured by Bruker, atomic force microscope, model: MultiMode 8
Mode: Peak Force QNM tapping mode
Scan size: 2 μm×2 μm
Scan speed: 1.0 Hz
Maximum number of samples: 256×256 samples/line
Peak force setpoint: 20 nN
Peak force frequency: 2 kHz
Modulus fit model: Johnson-Kendall-Roberts (JKR)
Frequency (F): 70 Hz
•Cantilever
Model: 240AC-NA (MikroMasch)
Spring constant: 2 N/m

3. Pressure-sensitive Adhesive Strength

The resultant pressure-sensitive adhesive tape was cut out into a size of 20 mm wide by 80 mm long, and was

pressure-bonded to the mirror surface of a silicon mirror wafer (manufactured by Shin-Etsu Handotai Co., Ltd.) by reciprocating a hand roller once under an atmosphere at 23°C. The resultant was left to stand at 23°C for 30 minutes. After that, a strength required for peeling the pressure-sensitive adhesive tape was measured under an atmosphere at 23°C and 50%RH and under the conditions of 90° peeling and a tensile rate of 300 mm/min. The strength was defined as a pressure-sensitive adhesive strength before UV.

In addition, the pressure-sensitive adhesive tape was pressure-bonded to the silicon mirror wafer by the same method as described above, and the resultant was left to stand at 23°C for 30 minutes. Next, the pressure-sensitive adhesive tape was irradiated with UV light (UV) (integrated light quantity: 460 $mJ/cm^2$ (365 nm conversion)) from a pressure-sensitive adhesive tape surface side. After that, a strength required for peeling the pressure-sensitive adhesive tape was measured under an atmosphere at 23°C and 50%RH and under the conditions of 90° peeling and a tensile rate of 300 mm/min. The strength was defined as a pressure-sensitive adhesive strength after UV.

4. Size and Ratio of Island Portion

The obtained storage elastic modulus mapping images were subjected to binarization treatment with free software (ImageJ). Any appropriate ten island portions were selected from the island portions in each storage elastic modulus mapping image. Their sizes were measured, and an average of the measured values was defined as the size of the island portion. The size of the island portion was set to be the length of a part of each island portion having the maximum length. In addition, the ratio of the island portion in the mapping image was calculated from the image subjected to binarization treatment.

Table 2

| | | Example 1 | Example 2 | Example 3 | Example 4 | Comparative Example 1 | Comparative Example 2 |
|---|---|---|---|---|---|---|---|
| Polymer (part(s) by weight) | A | 100 | - | - | - | - | - |
| | B | - | 100 | 100 | - | - | - |
| | C | - | - | - | 100 | - | - |
| | D | - | - | - | - | 100 | - |
| | E | - | - | - | - | - | 100 |
| UV-curable resin (part(s) by weight) | UW-9102 | 100 | 100 | 50 | 100 | 100 | 50 |
| | UV-W300 | - | - | 50 | - | - | - |
| Cross-linking agent (part(s) by weight) | V-04 | 0.2 | - | - | - | - | - |
| Thickener (part(s) by weight) | SN-THICKENER 612 | - | - | - | 1 | - | - |
| Leveling agent (part(s) by weight) | SW-C | - | - | - | 1 | - | - |
| Photoinitiator (part(s) by weight) | TPO-L | 3 | 3 | - | 3 | 3 | - |

(continued)

| | | Example 1 | Example 2 | Example 3 | Example 4 | Comparative Example 1 | Comparative Example 2 |
|---|---|---|---|---|---|---|---|
| AFM mapping image | Low elastic modulus | Island | Island | Island | Island | Sea | - |
| | High elastic modulus | Sea | Sea | Sea | Sea | Island | - |
| | Size of island portion (nm) | 80 | 75 | 82 | 80 | 78 | - |
| | Ratio of island portion (%) | 20 | 16 | 18 | 20 | 30 | - |
| | Image | FIG. **3** | FIG. **4** | FIG. **5** | FIG. **6** | FIG. **7** | FIG. **8** |
| Pressure-sensitive adhesive strength at 90°C (N/20 mm) | Before UV | 6.8 | 5.5 | 6.5 | 5.2 | 4.2 | 1.8 |
| | After UV | 0.18 | 0.15 | 0.1 | 0.1 | 0.35 | 0.3 |
| UW-9102: manufactured by UBE Corporation, product name: "ETERNACOLL UW-9102"<br>UV-W300: manufactured by Mitsubishi Chemical Corporation, product name: "SHIKOH UV-W300"<br>V-04: manufactured by Nisshinbo Chemical Inc., product name: "CARBODILITE V-04"<br>SN-THICKENER 612: manufactured by San Nopco Limited, product name: "SN-THICKENER 612"<br>SW-C: manufactured by DKS Co. Ltd., product name: "NEOCOL SW-C"<br>TPO-L: manufactured by IGM Resins B.V., product name: "Omnirad TPO-L" | | | | | | | |

In each of the pressure-sensitive adhesive tapes of Examples of the present invention, a pressure-sensitive adhesive layer surface after active energy ray irradiation had a microphase-separated structure serving as a sea-island structure. The pressure-sensitive adhesive tapes of Examples of the present invention each had a high pressure-sensitive adhesive strength before active energy ray irradiation and a sufficiently reduced pressure-sensitive adhesive strength after UV irradiation, and were hence able to achieve both of adhesiveness to an adherend and light peelability.

The pressure-sensitive adhesive tape according to at least one embodiment of the present invention can be suitably used in an application for semiconductor wafer processing.

## Claims

**1.** A pressure-sensitive adhesive tape, comprising:

a base material; and
a pressure-sensitive adhesive layer formed of an active energy ray-curable pressure-sensitive adhesive,
wherein a surface of the pressure-sensitive adhesive layer after active energy ray irradiation has a microphase-separated structure including an island portion and a sea portion having a storage elastic modulus higher than a storage elastic modulus of the island portion, in a storage elastic modulus mapping image obtained with an atomic force microscope.

**2.** The pressure-sensitive adhesive tape according to claim 1, wherein the island portion has a size of 300 nm or less.

**3.** The pressure-sensitive adhesive tape according to claim 1, wherein the active energy ray-curable pressure-sensitive adhesive is a water-dispersed pressure-sensitive adhesive.

**4.** The pressure-sensitive adhesive tape according to claim 3, wherein the active energy ray-curable pressure-sensitive adhesive contains a water-dispersed acrylic polymer and an active energy ray-curable resin.

**5.** The pressure-sensitive adhesive tape according to claim 4, wherein the water-dispersed acrylic polymer is a polymer

having a core-shell type structure.

**6.** The pressure-sensitive adhesive tape according to claim 5, wherein the water-dispersed acrylic polymer includes a shell portion having a glass transition temperature Tg of -10°C or more and a core portion having a glass transition temperature Tg of less than -10°C.

**7.** The pressure-sensitive adhesive tape according to any one of claims 1 to 6, wherein the pressure-sensitive adhesive tape is used for semiconductor wafer processing.

FIG.1

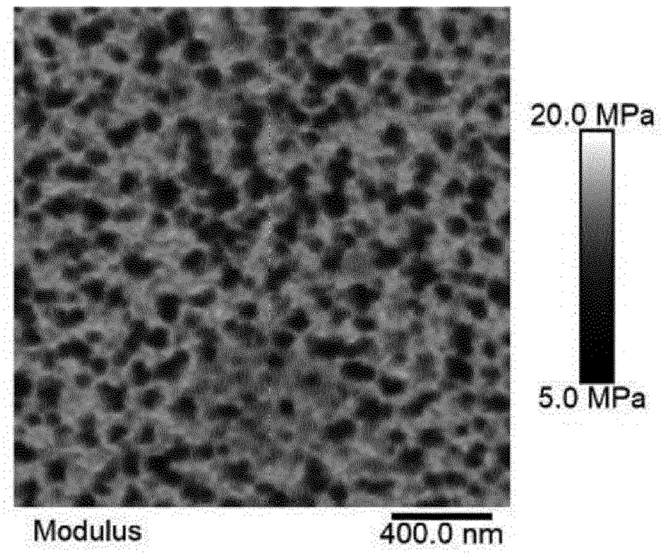


FIG.2

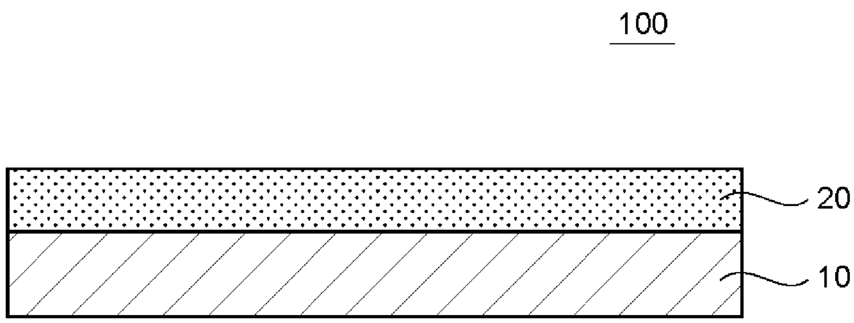

FIG.3

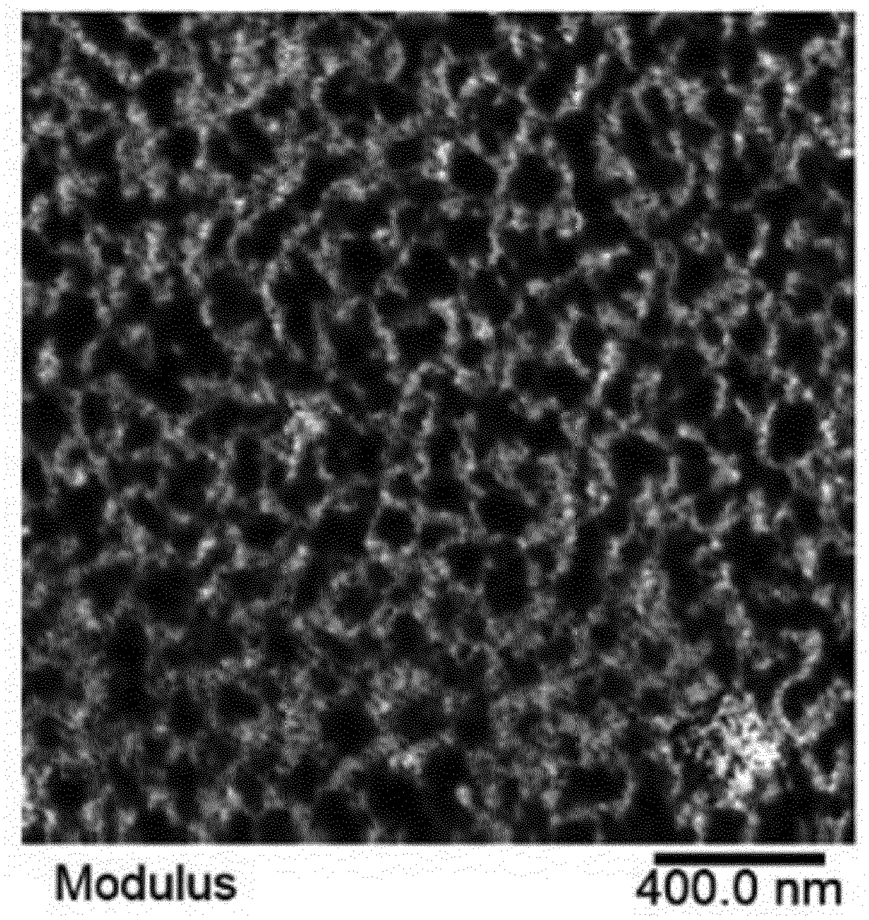

FIG.4

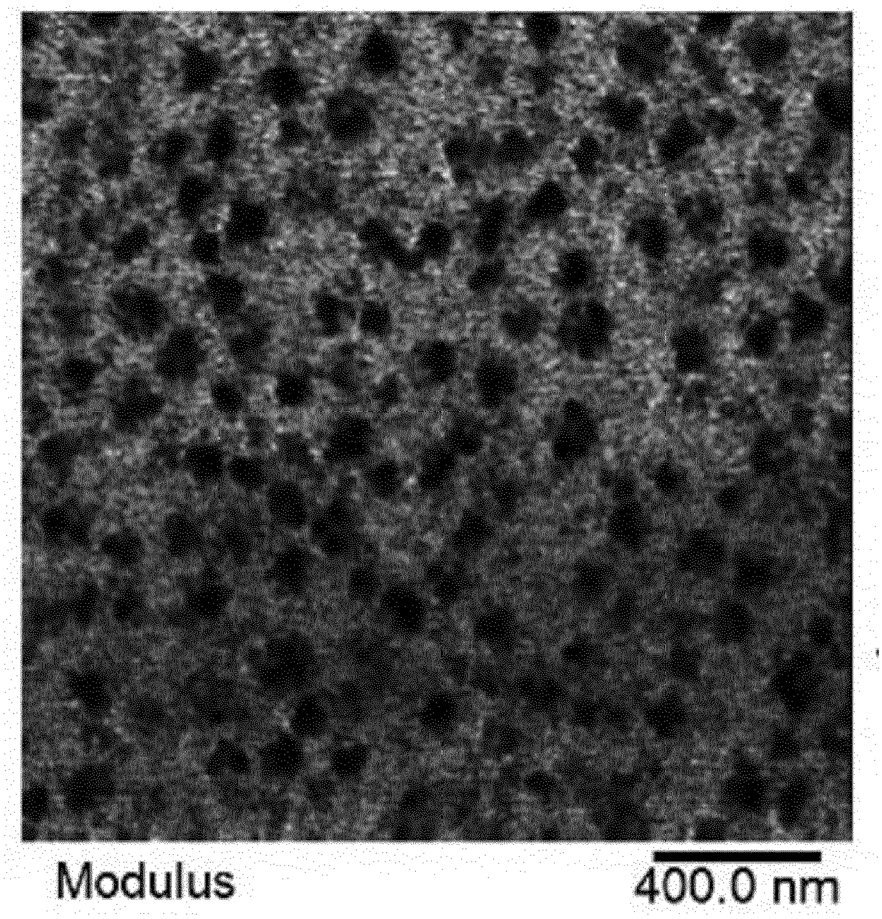

FIG.5

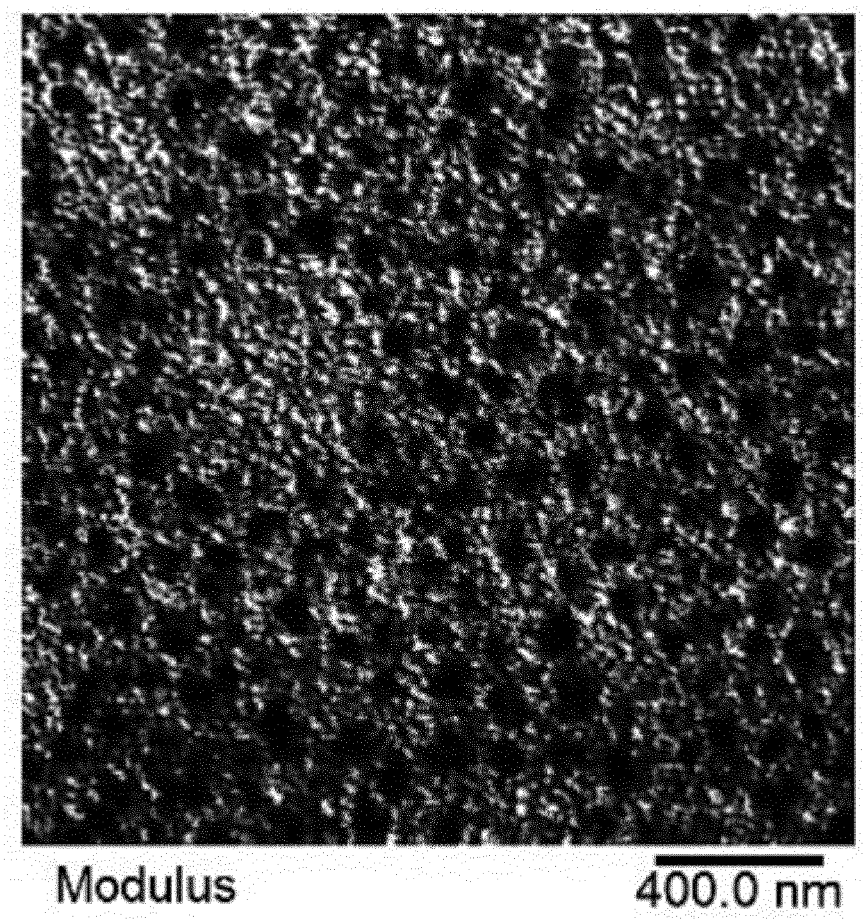

FIG.6

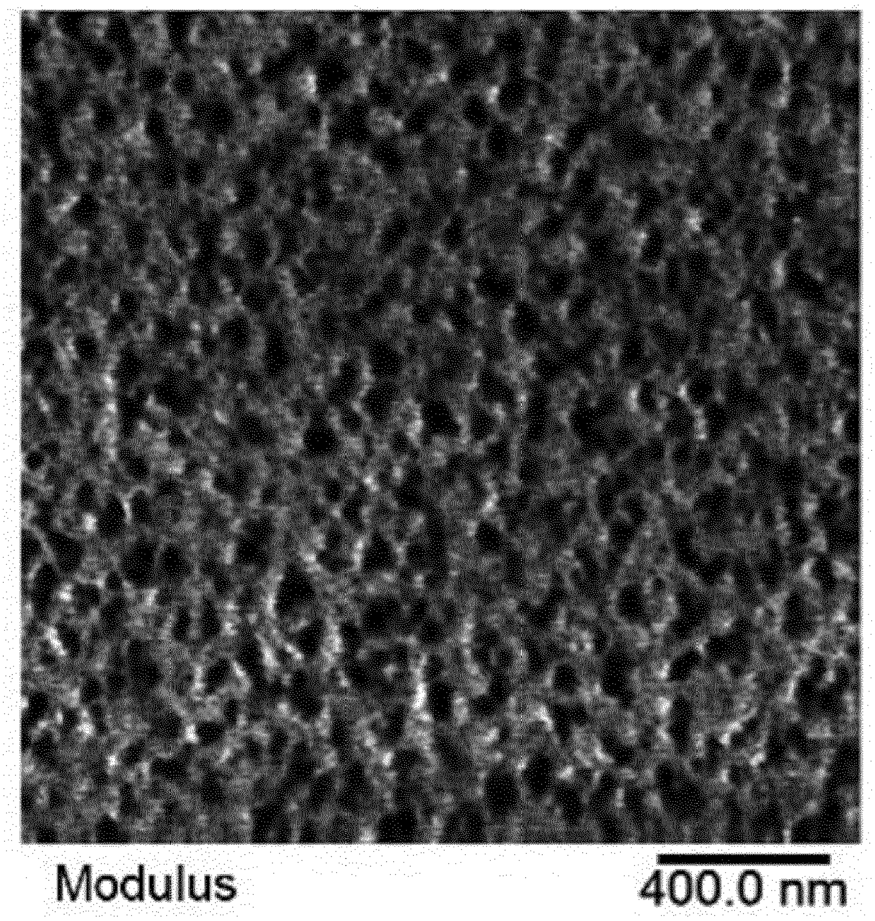

FIG.7

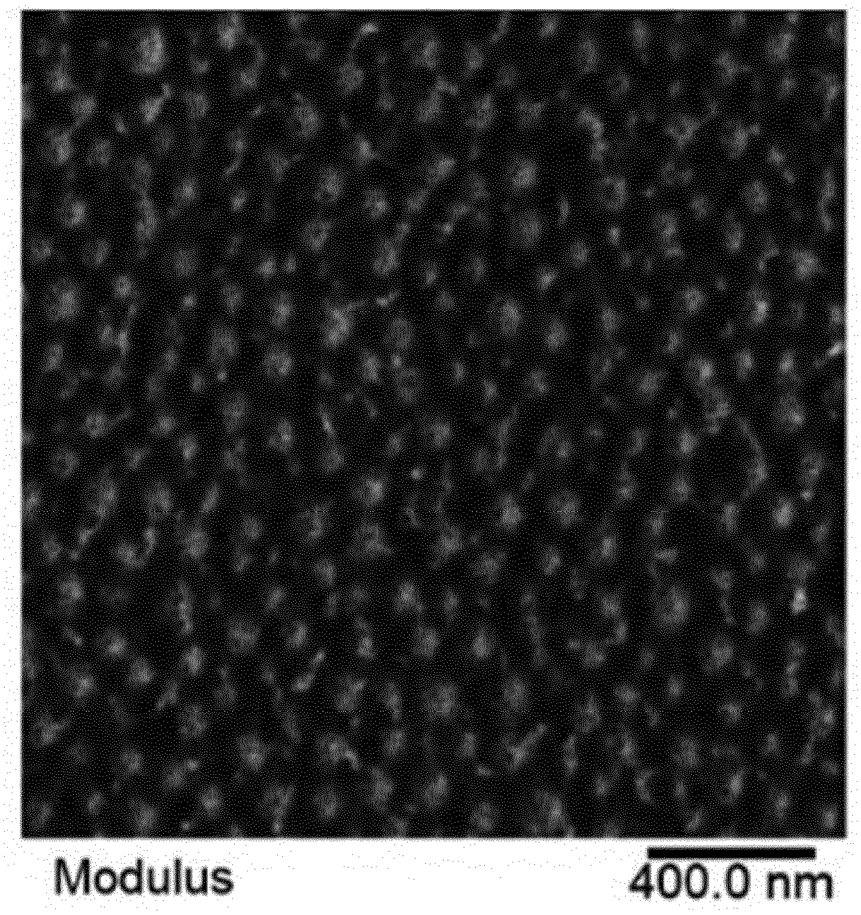

FIG.8

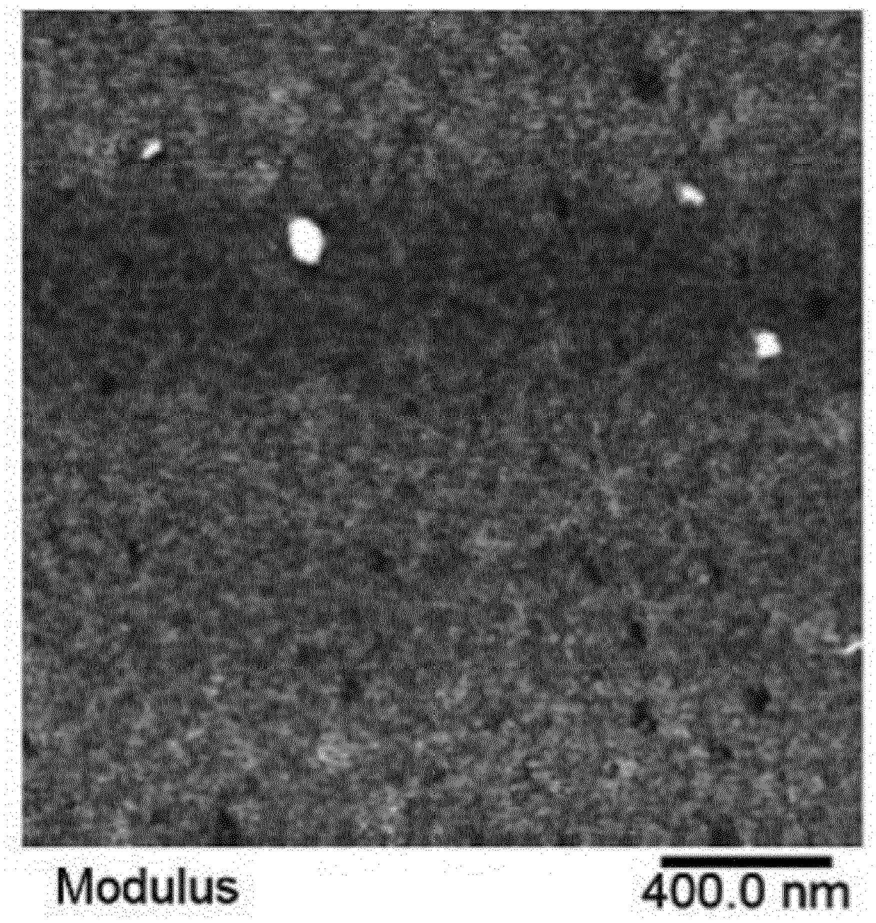

Europäisches Patentamt
European Patent Office
Office européen des brevets

# EUROPEAN SEARCH REPORT

Application Number
EP 25 18 2988

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2012 001615 A (NIPPON SYNTHETIC CHEM IND) 5 January 2012 (2012-01-05)<br>* paragraphs [0001], [0010], [0021], [0029], [0040], [0066], [0087], [0092], [0128]; claims 1-9 *<br>* paragraphs [0132] - [0145]; examples 1-4; table 1 *<br>----- | 1-7 | INV.<br>C09J7/38<br>H01L21/683 |
| A | KR 2022 0161081 A (INNOX ADVANCED MAT CO LTD [KR]) 6 December 2022 (2022-12-06)<br>* paragraphs [0001] - [0025], [0071] - [0085]; claims 1-11 *<br>----- | 1-7 | |
| A | JP 2004 346296 A (NITTO DENKO CORP) 9 December 2004 (2004-12-09)<br>* paragraphs [0001] - [0018], [0027], [0054]; claims 1-9 *<br>----- | 1-7 | |
| A | JP 2008 019341 A (NITTO DENKO CORP) 31 January 2008 (2008-01-31)<br>* paragraphs [0001] - [0035], [0079]; claims 1-5; examples 1-3 *<br>----- | 1-7 | TECHNICAL FIELDS SEARCHED (IPC)<br>C09J<br>C08F<br>H01L |

The present search report has been drawn up for all claims

2

| Place of search | Date of completion of the search | Examiner |
|---|---|---|
| Munich | 17 October 2025 | Alevizopoulou, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
........................................
& : member of the same patent family, corresponding document

EPO FORM 1503 03.82 (P04C01)

## ANNEX TO THE EUROPEAN SEARCH REPORT ON EUROPEAN PATENT APPLICATION NO. EP 25 18 2988

This annex lists the patent family members relating to the patent documents cited in the above-mentioned European search report. The members are as contained in the European Patent Office EDP file on
The European Patent Office is in no way liable for these particulars which are merely given for the purpose of information.

17-10-2025

| Patent document cited in search report | Publication date | Patent family member(s) | Publication date |
|---|---|---|---|
| JP 2012001615 A | 05-01-2012 | JP 5474673 B2 | 16-04-2014 |
| | | JP 2012001615 A | 05-01-2012 |
| KR 20220161081 A | 06-12-2022 | CN 115404015 A | 29-11-2022 |
| | | KR 20220161081 A | 06-12-2022 |
| | | TW 202246439 A | 01-12-2022 |
| JP 2004346296 A | 09-12-2004 | JP 4606010 B2 | 05-01-2011 |
| | | JP 2004346296 A | 09-12-2004 |
| JP 2008019341 A | 31-01-2008 | JP 5132096 B2 | 30-01-2013 |
| | | JP 2008019341 A | 31-01-2008 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019031620 A
- JP 2007051271 A


### Non-patent literature cited in the description


- Polymer Handbook. John Wiley & Sons, Inc., 1989